# EUROPEAN PATENT SPECIFICATION

(11) **EP 3 614 430 B1**
(45) Date of publication and mention of the grant of the patent: **25.11.2026**
(21) Application number: 17906172.6
(22) Date of filing: 10.05.2017
(51) Int. Cl.: H10D 30/67, H10D 64/62, H10D 62/80

(54) **MANUFACTURING METHOD OF DISPLAY SUBSTRATE**
HERSTELLUNGSVERFAHREN FÜR EIN ANZEIGESUBSTRAT
PROCÉDÉ DE FABRICATION DE SUBSTRAT MATRICIEL

(30) Priority: 20.04.2017 CN 201710263476
(43) Date of publication of application: 26.02.2020
(73) Proprietor: Shenzhen China Star Optoelectronics Technology Co., Ltd., Shenzhen, Guangdong 518132 (CN)
(72) Inventor: YU, Xiaoping, Shenzhen Guangdong 518132 (CN)
(74) Representative: Murgitroyd & Company
(86) International application number: PCT/CN2017/083688
(87) International publication number: WO 2018/192020

(56) References cited:
- CN-A- 103 359 711
- CN-A- 103 880 001
- CN-A- 104 409 515
- CN-A- 104 409 515
- CN-A- 104 966 722
- CN-A- 105 304 495
- CN-A- 105 304 495
- CN-A- 105 336 861
- CN-U- 204 927 297
- US-A1- 2013 048 948
- US-A1- 2017 294 516

## Description

### TECHNICAL FIELD OF INVENTION

The present invention relates to flat panel display field, and more particularly, to a method of manufacturing a display substrate.

### BACKGROUND OF INVENTION

A liquid crystal display (LCD) is advantageous because of it is small, light, low power, and no radiation, and has extensive application of optics, semiconductor, electrical engineering, chemical engineering, and material.

If doping concentration of a semiconductor is very heavy when the semiconductor contacts a metal, width of a barrier becomes thin. Carriers can pass the barrier via tunneling effect and large current can be generated. Ohmic contact is formed between the metal and the semiconductor. Value of the ohmic contact resistor between the semiconductor and the metal in LCD substrate can influence the performance of the semiconductor device.

The conventional material of ohmic contact layer is n-type doping silicon. However, through long-term research, the inventor of the present invention finds that the ohmic contact layer of n-type silicon has shortage of large leakage current and low on/off ratio, and conduction between the semiconductor and the metal is low.

CN104409515A discloses an oxide film transistor and a manufacturing method thereof. An active layer of the oxide film transistor can be prevented from destruction on the premise of few times of composition processes.

CN204927297U discloses a thin film transistor, an array substrate, and a display device that can adopt copper and copper alloy as electrode material to prevent the copper oxidation.

CN103359711A discloses a method for manufacturing nitrogen-doped graphene. In the method, an oxidative thermal reduction method is utilized to prepare the single-layer nitrogen-doped graphene, so that the preparation is simple in equipment and process, convenient to operate, cheap in raw materials, low in cost and easy in achievement of large-scale industrial production.

CN105304495A discloses a thin film transistor and a producing method thereof, and an array substrate, which belong to a technical field of the thin film transistor, can solve a problem of poor performance of a conventional thin film transistor. The producing method of the thin film transistor comprises: S1: forming a gate electrode composed of graphene; S2: forming a gate insulating layer composed of oxidized graphene; S3: forming an active region composed of doped oxidized graphene or doped graphene; S4: forming a source electrode and a drain electrode composed of graphene, wherein, the graphene composing the source electrode, the drain electrode and the gate electrode is formed by reducing oxidized graphene, and the doped oxidized graphene or doped graphene composing the active region is formed by treating oxidized graphene.

### SUMMARY OF INVENTION

The main technical problem of the present invention is to provide a method of manufacturing a display substrate. It can form excellent conduction between the semiconductor layer and a metal electrode layer, and apparently improve performance of semiconductor device.

To resolve the technical problem above, the present invention provides a method of manufacturing a display substrate, comprising steps of: forming a first electrode layer, an insulating layer, and a semiconductor layer on a substrate successively; and forming an n-type doping graphene layer comprising a nano pattern on the semiconductor layer.

The benefit of the present invention is distinct from the conventional art. In the array substrate of the present invention, the n-type doping graphene layer has better conductivity and high electron mobility so its ohmic contact resistor is small, leakage current is small, and on/off ratio is high. Therefore, the conduction between the semiconductor layer and the source and drain electrode layer is excellent and the performance of the semiconductor device is improved significantly.

### BRIEF DESCRIPTION OF THE DRAWINGS

The accompanying drawings are included to provide easy understanding of the application, are incorporated herein and constitute a part of this specification. The drawings illustrate embodiments of the application and, together with the description, serve to illustrate the principles of the application.
FIG. 1 is a schematic view of an array substrate in accordance with an embodiment of the present invention.
FIG. 2 is a flow chart of manufacturing a display substrate in accordance with an embodiment of the present invention.
FIGS. 3 and 4 are schematic views of a process of manufacturing a display substrate in accordance with an embodiment of the present invention.
FIG. 5 is a flow chart of manufacturing a nitrogen-doped graphene layer in accordance with an embodiment of the present invention.
FIGS. 7-11 are schematic views of a process of manufacturing the nitrogen-doped graphene layer in accordance with an embodiment of the present invention.

### DETAILED DESCRIPTION OF THE INVENTION

To better and concisely explain the disclosure, the same name or the same reference number given or appeared in different paragraphs or figures along the specification should has the same or equivalent meanings while it is once defined anywhere of the disclosure.

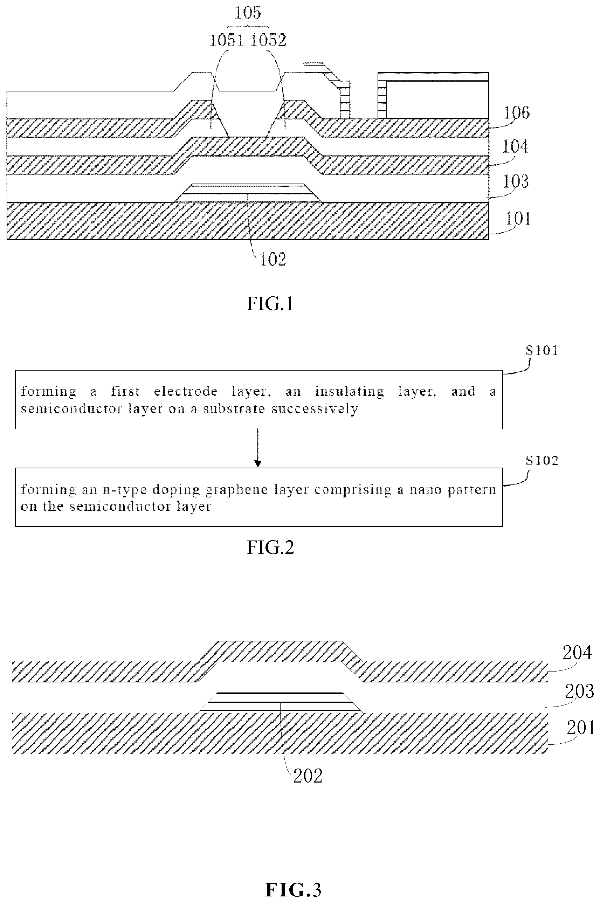

Referring FIG.1, FIG. 1 is a schematic view of an array substrate in accordance with an embodiment of the present invention. The array substrate includes a glass substrate 101; a gate electrode layer 102 formed on the glass substrate 101; an insulating layer 103 covering the glass substrate 101 and the gate electrode layer 102; a semiconductor layer 104 covering the insulating layer 103; and an n-type doping graphene layer 105 formed on the semiconductor layer 104, wherein the n-type doping graphene layer 105 includes a first n-type doping graphene layer 1051 and a second doping n-type graphene layer 1052. The first n-type doping graphene layer 1051 is located next to the second n-type doping graphene layer 1052, and they are on two sides of top of the gate electrode layer 102. The first n-type doping graphene layer 1051 and the second n-type doping graphene layer 1052 overlap a portion of the gate electrode layer 102 respectively. A source and drain electrode layer 106 formed on the n-type doping graphene layer 105.

The glass substrate 101 can be transparent glass. In some applications, it can adopt SiO2 substrate, polyvinyl chloride (PV) substrate, polytetrafluoro ethylene (PFA) substrate, or polyethylene terephthalate (PET) substrate.

The gate electrode layer 102 can be single metal layer or composite metal layer such as Cr, Mo, Mo/Al, MoTi, and Cu.

The insulating layer 103 can be SiNx. In some applications, it can be SiOx. The insulating layer 103 can be made of other insulating materials in other applications.

The semiconductor layer 104 can be amorphous silicon material. It is selected from a group consisting of indium oxide, zinc oxide, tin oxide, and gallium oxide in some applications.

The graphene is a new nano carbon material, and has high strength and thermal conductivity, and great conductivity and electron mobility. Zero bandgap of the graphene brings problem such as large leakage current and low on/off ratio in electrical device application as well. Executing controllable doping and bandgap adjustment to graphene, n-type doping graphene for example, can modify intrinsic graphene so the doping graphene has better property and reduces more contact resister between a first electrode and the semiconductor layer than the intrinsic graphene does. Specifically, the n-type doping graphene layer 105 can be formed by doping nitrogen or phosphorous and at least one of chemical vapor deposition and solution reaction. The n-type graphene layer 105 can be patterned to have particular pattern by a specific process such as lithography. Nano pattern can be formed on the n-type doping graphene layer 105 by nano imprinting. The method is not limited.

The source and drain electrode layer 106 is similar to the n-type doping graphene layer 105, and has two parts which located next to each other and on two sides of top of the gate electrode layer 102. The first part and the second part overlaps portions of the gate electrode layer 102 respectively.

The array substrate of the present invention includes the glass substrate 101; the gate electrode layer 102 formed on the glass substrate 101; the insulating layer 103 covering the glass substrate 101 and the gate electrode layer 102; the semiconductor layer 104 covering the insulating layer 103; and the n-type doping graphene layer 105 formed on the semiconductor layer 104, wherein the n-type doping graphene layer 105 includes the first n-type doping graphene layer 1051 and the second n-type doping graphene layer 1052. The first n-type doping graphene layer 1051 is located next to the second n-type doping graphene layer 1052, and they are on two sides of top of the gate electrode layer 102. The first n-type doping graphene layer 1051 and the second n-type doping graphene layer 1052 overlap portions of the gate electrode layer 102 respectively. The source and drain electrode layer 106 formed on the n-type doping graphene layer 105. The n-type doping graphene has better conductivity and high electron mobility so its ohmic contact resistor is small, leakage current is small, and on/off ratio is high. Therefore, the conduction between the semiconductor layer 104 and the source and drain electrode layer 106 is excellent and the performance of the semiconductor device is improved significantly.

Referring to FIGs. 2-4, the present invention provides a method of manufacturing a display substrate includes steps below.

S101, forming a first electrode layer 202, an insulating layer 203, and a semiconductor layer 204 on a substrate 201 successively.

The substrate 201 can be transparent material such as transparent water-oxgen-isolating organic material or glass specifically. It can be glass substrate and SiO2 substrate. It can be polyvinyl chloride (PV), polytetrafluoro ethylene (PFA), or polyethylene terephthalate (PET) as well in some applications.

The first electrode layer 202 can be formed by forming a metal layer on the substrate 201 through metal sputter deposition. The first electrode layer 202 can have a predefined pattern by coating photoresist, exposure, developing, etching, and removing the photoresist.

The insulating layer 203 can be formed on the first electrode layer 202 by chemical vapor deposition and lithography.

The method of forming the semiconductor layer 204 is similar to that of forming the first electrode layer 202 so it is not iterated.

It is easy to be comprehended that it can adopt other method such as spray to form the first electrode layer 202, the insulating layer 203, and the semiconductor layer 204. It is not limited.

S102, forming an n-type doping graphene layer 205 having nano pattern on the semiconductor layer 204.

The n-type doping graphene layer 205 can be formed by transferring an n-type doping graphene thin film to the semiconductor layer 204. It can be formed by coating n-type doping graphene solution on the semiconductor layer 204 through spin coating and slit coating.

The n-type doping graphene is nitrogen-doped graphene or, in an example which does not belong to the claimed invention, phosphorous doping graphene.

The nano pattern of the n-type doping graphene layer can be formed by at least one of lithography, soft etching, and nano imprinting.

Furthermore, after the n-type doping graphene layer 205 having nano pattern formed on the semiconductor layer 204, a second electrode layer (a source and drain electrode layer), a protective layer, and an ITO electrode layer are formed on the n-type doping graphene layer 205. Thus, a complete Thin Film Transistor (TFT) substrate is provided. A color photoresist layer can further be formed on the TFT substrate to provide a Color Filter on Array (COA) structure.

Moreover, it proceeds processes of coating polyimide (PI) and One Drop Filling (ODF) to produce a display device. The display device is applied with external voltage to tilt liquid crystal and performs liquid crystal displaying.

In this embodiment, the intrinsic graphene or amorphous silicon is replaced by n-type doping graphene. The n-type doping graphene has excellent conductivity and electron mobility so its ohmic contact resistor is low. Therefore, the conduction between the semiconductor and the source and drain electrode is better and the performance of the semiconductor device is improved significantly. The manufacture of the substrate is elegant because of forming the nano pattern and it provides technical support to increase resolution of display panel so display quality is improved.

In an embodiment, the n-type doping graphene layer is a nitrogen-doped graphene layer. Before the step S102, it further includes a step S201, providing nitrogen -doped graphene.

Specifically, the nitrogen-doped graphene can be formed by chemical vapor deposition and solution reaction.

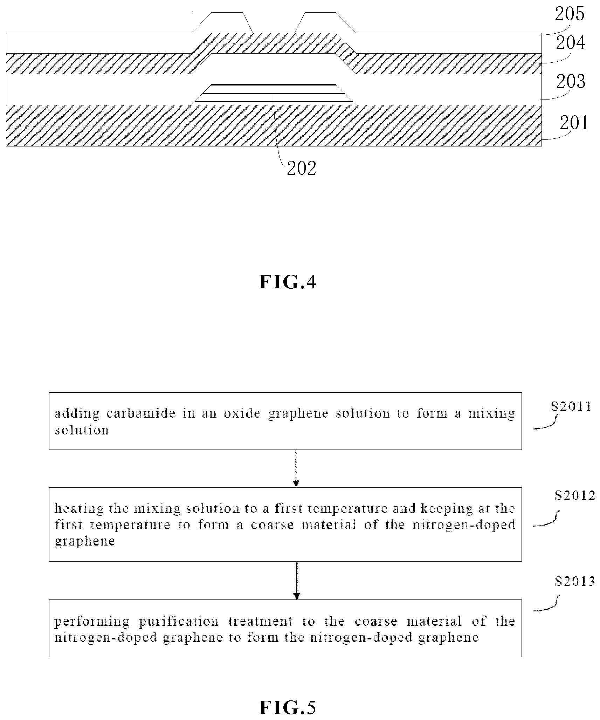

Referring FIG. 5, FIG. 5 is a flow chart of manufacturing a nitrogen-doped graphene layer in accordance with an embodiment of the present invention. Solution reaction is adopted to manufacture the nitrogen-doped graphene layer. The step S201 includes substeps S2011, S2012, and S2013.

S2011, adding carbamide in an oxide graphene solution to form a mixing solution.

The oxide graphene solution can be formed by blending oxide graphene with an amount of solvent. The solvent can be organic solvent such as ethanol and acetone, or water. The concentration of the oxide graphene solution can be 0.1~5mg/mL. Particularly, it can be selected from a group consisting of 0.1mg/mL, 0.5mg/mL, 1mg/mL, 1.5mg/m, 2mg/mL, 2.5mg/mL, 3mg/mL, 3.5mg/mL, 4mg/mL, 4.5mg/mL, and 5mg/mL. In this embodiment, the concentration of the oxide graphene solution is 0.5mg/mL and volume is 30mL.

Carbamide can be carbamide pure matter or an amount of carbamide solution. The mass ratio of oxide graphene to pure carbamide is 1 : 5~1 : 50. It can be selected from a group consisting of 1 : 5, 1 : 10, 1 : 15, 1 : 20, 1 : 25, 1 : 30, 1 : 35, 1 : 40, 1 : 45, and 1 : 50. In this embodiment, the mass of the pure carbamide is 450mg.

In an application, the mixing solution above can be blended by magnetic mixer for 30 minutes.

Substep S2012, heating the mixing solution to a first temperature and keeping at the first temperature to form a coarse material of the nitrogen-doped graphene.

The mixing solution of oxide graphene and carbamide is heated. The range of heating temperature is 120~250°C. It can be selected from a group consisting of 120°C, 140°C, 160°C, 180°C, 200°C, 225°C, and 250°C and react for 2~3 hours. In this embodiment, the mixing solution in hydrothermal reaction kettle is heated to 160°C and reacts for 3 hours. Nitrogen-doped graphene solid is separated out to form the coarse material of the nitrogen-doped graphene.

Substep S2013, performing purification treatment to the coarse material of the nitrogen-doped graphene to form the nitrogen-doped graphene.

The purification treatment is to cool the coarse material of the nitrogen-doped graphene. It can adopt natural cooling or ice water to assist cooling. After cooling the coarse material of the nitrogen-doped graphene, it can be centrifuged in a centrifugal machine to deposit the reacting nitrogen-doped graphene and separate the nitrogen-doped graphene solid from the reactant. The centrifugal machine can be a low-speed centrifugal machine, a high-speed centrifugal machine, or a super-speed centrifugal machine, and be selected according to the requirement. After centrifuging, the depositing nitrogen-doped graphene solid is separated from the liquid by filtering, rinsed, and dried to form nitrogen-doped graphene black solid. It is noted that it can adopt centrifuge treatment and purification treatment multiple times to form purer nitrogen-doped graphene, for ensuring the purity of samples.

This embodiment is to adopt oxide graphene and carbamide as material and manufacture the nitrogen-doped graphene by hydrothermal reaction. It is low-temperature process, and moderate reaction condition, easy operation, no toxin, low environment pollution, short reacting time, high reacting efficiency, and cost saving.

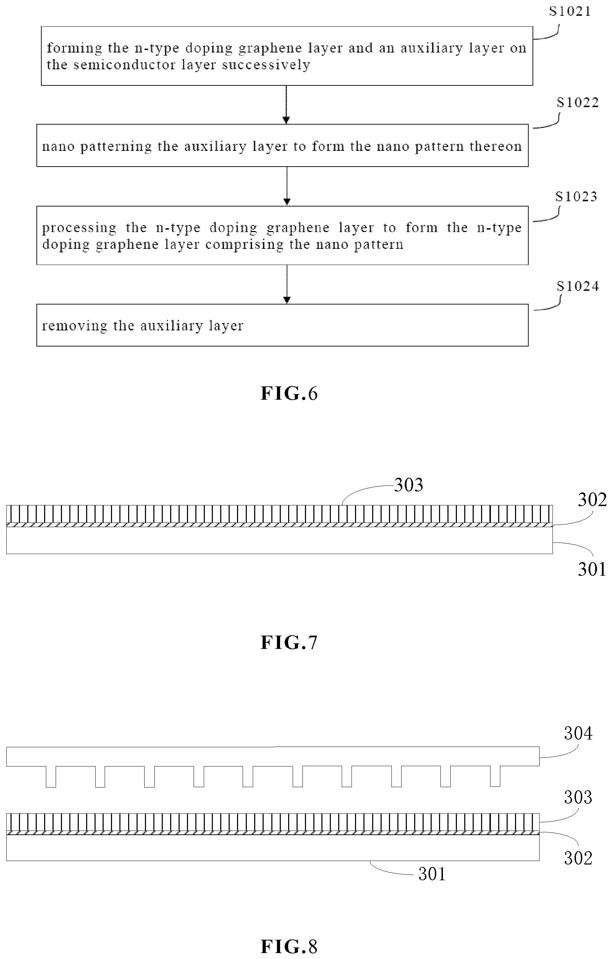

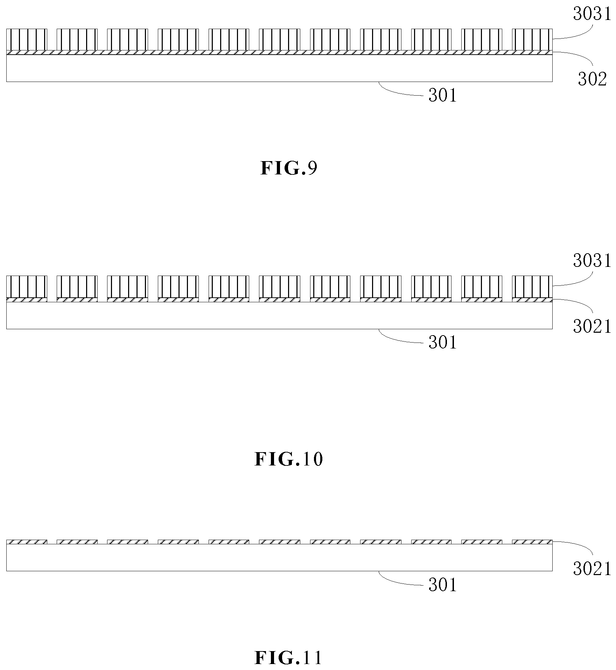

Referring to FIGS. 6-11, the step S102 of forming the nitrogen-doped graphene layer having nano pattern includes substeps S1021, S1022, S1023, and S1024.

Substep S1021, forming the n-type doping graphene layer 302 and an auxiliary layer 303 on the semiconductor layer 301 successively.

Material of the auxiliary layer 303 can be selected from a group consisting of polymethyl methacrylate (PMMA), polystyrene (PS), polycarbonate (PC), and polyvinyl chloride(PVC). In an application, the auxiliary layer 303 is capable of nano imprinting.

Adopting PMMA as an example in this embodiment, the forming method of the auxiliary layer 303 is to coat PMMA of liquid on the substrate 201 by spin coating. PMMA of liquid is coated uniformly and cured to form PMMA layer. It also can adopt other coating such as spray coating, dip coating, electrophoresis painting, and squeegee.

Substep S1022, nano patterning the auxiliary layer 303 to form the nano pattern thereon.

Nano patterning the auxiliary layer 303 can be selected from a group consisting of photolithography, electron beam lithography, x-ray lithography, extreme ultraviolet lithography, vacuum ultraviolet lithography, soft etching, and nano imprinting. In an application, the auxiliary layer 303 is nano patterned by nano imprinting to form nano pattern. Adopting nano imprinting can form 3-dimension artificial structure of which resolution is nano scale on the PMMA layer according to requirement and perform nano patterning. Nano imprinting does not have diffraction in photolithography, scattering in electron beam lithography, and high resolution. It can parallel process like photolithography and manufacture thousands of devices simultaneously so there is advantage of large production. In the meantime, the nano imprinting is not similar to optical exposure machine requiring complicated optic system or electron beam exposure machine requiring complicated electromagnetic focusing system, and has low cost. It can transfer the pattern of the mask to a wafer without difference and has high fidelity.

The nano imprinting includes thermal nano imprinting lithography, ultraviolet curing nano imprinting, micro contact nano imprinting, and soft imprinting. In this embodiment, the auxiliary layer 303 is nano patterned by thermal nano imprinting lithography.

Material of an imprinting mold 304 for nano patterning can be that of high accuracy, large hardness, and stable chemical property such as SiC, Si₃N₄, or SiO₂. The requiring nano pattern can be formed on the imprinting mold 304 by electron beam lithography or reactive ion etching.

Adopting PMMA as an example, thermally imprinting the auxiliary layer 303 to form nano pattern can include heating PMMA layer to a temperature over glass transition temperature thereof, wherein the heating method can include heating plate or ultrasonic. Adopting ultrasonic can shorten the heating process in few seconds and benefit to lower power consumption, increase production, and reduce cost. After heating, it provides pressure on the imprinting mold 304, and keeps the heating temperature and the pressure for a while. The PMMA of liquid fills nano pattern gaps of the imprinting mold 304, is cooled down to be lower the glass transition temperature, and is demolded. Thus, the PMMA layer completes the nano patterning process.

In an application, for reducing influence of gas bubble to quality of transferring pattern, full process proceeds in vacuum of which pressure is less 1pa. Vacuum can assist gas in the auxiliary layer 303 to be discharged and reduce influence of gas bubble to pattern quality so nano pattern quality can be improved.

In an application, adopting gas can assist nano imprinting. The imprinting mold 304 and the substrate having the auxiliary layer 303 are aligned and set in a vacuum chamber before imprinting, and inert gas is filled into the vacuum chamber to raise pressure. Adopting gas pressure includes uniform pressure and amount of pressure can be controlled by amount of gas intake. It can avoid problem of adaptive calibration of multiple freedom degree adopted by a carrier in mechanical pressure and simplify fabrication process.

Substep S1023, processing the n-type doping graphene layer 302 to form the n-type doping graphene layer 3021 comprising the nano pattern.

In an application, processing the n-type doping graphene layer 302 can adopt plasma surface treatment, photolithography, and laser lithography. In this embodiment, the pattern formed on the n-type doping graphene layer 302 by plasma surface treatment is the same as that on a nano pattern auxiliary layer 3031.

Substep S1024, removing the auxiliary layer 3031.

In this embodiment, after forming nano electrode pattern on the n-type doping graphene layer 302, the nano pattern auxiliary layer 3031 can be removed.

Removing the nano pattern auxiliary layer 3031 can soak the nano pattern auxiliary layer 3031 in an organic solvent which can dissolve it. For PMMA, the organic solvent is selected from a group consisting of acetone, dimethylformaid (DMF), dichloromethane, chlorobenzene, toluene, tetrahydrofuran, and chloroform. It also can adopt alkaline solution such as NaOH solution. Of course, it can further adopt heating and ultrasonic to quicken removing PMMA layer.

In this embodiment, thermal imprinting process is simple and has high accuracy, and can form nano pattern of high quality and low cost. The manufacture of the substrate is elegant because of forming the nano pattern and it provides technical support to increase resolution of display panel so display quality is improved.

In an embodiment of the display substrate, the display substrate is manufactured by one of the methods of manufacturing the display substrate above. The method is as each embodiment above and it is not iterated. The display substrate of this embodiment can be thin film transistor array substrate or color filter array substrate. The display substrate of this embodiment adopts the n-type doping graphene layer as an ohmic contact layer so ohmic contact resistor is low and conduction among the semiconductor and the source electrode and the drain electrode is excellent. Thus, performance of the display device is improved.

In an embodiment of the display panel, the display panel includes the display substrate in one of the embodiments above. The display panel includes the display panel applied in electronic device such as TV, a computer, a tablet, a cell phone, MP3, and MP4. The display device of this embodiment has excellent performance and high display quality.

## Claims

1. A method of manufacturing a display substrate, wherein the method comprises steps of:
forming a first electrode layer (202), an insulating layer (203), and a semiconductor layer (204) on a substrate (201) successively;
forming an n-type doping graphene layer (205) comprising a nano pattern on the semiconductor layer (204); and
forming a source and drain electrode layer on the n-type doping graphene layer (205), wherein the n-type doping graphene layer is a nitrogen-doped graphene layer;
wherein the n-type doping graphene layer (105) is made by heating a mixing solution of oxide graphene and carbamide in a heating range of 120°C to 250°C for 2 to 3 hours, and nitrogen-doped graphene solid is separated out to form the n-type doping graphene layer;
wherein a mass ratio of the oxide graphene to the pure carbamide is 1 : 5 to 1 : 50.

2. The method of manufacturing a display substrate according to claim 1, wherein the mixing solution in hydrothermal reaction kettle is heated to 160°C and reacts for 3 hours.

## Patentansprüche

1. Verfahren zur Herstellung eines Anzeigesubstrats, wobei das Verfahren folgende Schritte umfasst:
aufeinanderfolgendes Bilden einer ersten Elektrodenschicht (202), einer Isolierschicht (203) und einer Halbleiterschicht (204) auf einem Substrat (201);
Bilden einer n-dotierten Graphen-Schicht (205), die ein Nanomuster auf der Halbleiterschicht (204) umfasst; und
Bilden einer Source- und Drain-Elektrodenschicht auf der n-dotierten Graphen-Schicht (205), wobei die n-dotierte Graphen-Schicht eine mit Stickstoff dotierte Graphen-Schicht ist;
wobei die n-dotierte Graphen-Schicht (105) hergestellt wird, indem eine Mischlösung aus Graphenoxid und Carbamid 2 bis 3 Stunden lang in einem Temperaturbereich von 120 °C bis 250 °C erhitzt wird und der stickstoffdotierte Graphen-Feststoff abgetrennt wird, um die n-dotierte Graphen-Schicht zu bilden;
wobei das Massenverhältnis von Graphenoxid zu reinem Carbamid 1 : 5 bis 1 : 50 beträgt.

2. Verfahren zur Herstellung eines Anzeigesubstrats nach Anspruch 1, wobei die Mischlösung in einem hydrothermalen Reaktionskessel auf 160 °C erhitzt wird und 3 Stunden lang reagiert.

## Revendications

1. Procédé de fabrication d'un substrat d'affichage, le procédé comprenant les étapes suivantes :
le dépôt successif d'une première couche d'électrode (202), d'une couche isolante (203) et d'une couche semi-conductrice (204) sur un substrat (201) ;
la formation d'une couche de graphène dopée de type n (205) comportant un nanomotif sur la couche semi-conductrice (204) ; et
la formation d'une couche d'électrodes de source et de drain sur la couche de graphène dopée de type n (205), la couche de graphène dopée de type n étant une couche de graphène dopée à l'azote ;
dans lequel la couche de graphène dopée de type n (105) est obtenue en chauffant une solution mélangeant de l'oxyde de graphène et du carbamide dans une plage de température comprise entre 120 °C et 250 °C pendant 2 à 3 heures, puis en séparant le solide de graphène dopé à l'azote afin de former la couche de graphène dopée de type n ;
dans lequel le rapport massique entre l'oxyde de graphène et le carbamide pur est compris entre 1:5 et 1:50.

2. Procédé de fabrication d'un substrat d'affichage selon la revendication 1, dans lequel la solution de mélange est chauffée à 160 °C dans une cuve de réaction hydrothermique et subit une réaction pendant 3 heures.
